# EUROPÄISCHE PATENTSCHRIFT

(11) **EP 1 377 984 B1**
(45) Veröffentlichungstag und Bekanntmachung des Hinweises auf die Patenterteilung: **11.04.2007**
(21) Anmeldenummer: 02714165.4
(22) Anmeldetag: 15.02.2002
(51) Int. Cl.: H01B 1/16, H05K 1/09

(54) **LEITFÄHIGKEITSPASTE, DAMIT ERZEUGTE ARTIKEL MIT EINER LEITFÄHIGEN BESCHICHTUNG AUF GLAS, KERAMIK ODER EMAILLIERTEM STAHL UND VERFAHREN ZU DEREN HERSTELLUNG**
CONDUCTIVE PASTE, ARTICLE PRODUCED THEREWITH WITH A CONDUCTIVE COATING ON GLASS, CERAMICS OR ENAMELED STEEL AND METHOD FOR THE PRODUCTION THEREOF
PATE DE CONDUCTIVITE, ARTICLE QU'ELLE PERMET DE REALISER COMPRENANT UN REVETEMENT CONDUCTEUR APPLIQUE SUR DU VERRE, DE LA CERAMIQUE OU DE L'ACIER EMAILLE, ET SON PROCEDE DE REALISATION

(30) Priorität: 04.04.2001 DE 10116653
(43) Veröffentlichungstag der Anmeldung: 07.01.2004
(73) Patentinhaber: Ferro GmbH, 60327 Frankfurt (DE)
(72) Erfinder: BECHTLOFF, Artur, 63067 Offenbach (DE); NIEMANN, Axel, 60385 Frankfurt am Main (DE); SCHREIBER, Stephan, 63456 Hanau (DE)
(74) Vertreter: Reinhardt, Markus
(86) Internationale Anmeldenummer: PCT/EP2002/001652
(87) Internationale Veröffentlichungsnummer: WO 2002/082466

(56) Entgegenhaltungen:
- FR-A- 2 798 509
- US-A- 4 122 232

## Beschreibung

Die Erfindung richtet sich auf eine Leitfähigkeitspaste zur Herstellung elektrisch leitfähiger Beschichtungen, insbesondere Leiterbahnen, auf Glas, Keramik oder emailliertem Stahl. Weitere Gegenstände der Erfindung richten sich auf ein Verfahren zur Herstellung der leitfähigen Beschichtungen sowie auf Artikel mit einer derartigen leitfähigen Beschichtung auf Glas, Keramik oder emailliertem Stahl, wie insbesondere Glasscheiben mit elektrischen Leiterbahnen.

Glasscheiben und Keramiksubstrate werden für elektrische und Elektronikzwecke oft mit Leiterbahnen oder ganzflächig mit einer leitfähigen Schicht versehen, wobei die auf dem Substrat eingebrannte Beschichtung ein oder mehrere elektrische Leitfähigkeit vermittelnde Metalle sowie eine Glaszusammensetzung als Bindemittel und Haftmittel auf dem Substrat enthält. In Abhängigkeit von ihrem Einsatzzweck enthalten derartige leitfähige Beschichtungen als Leitfähigkeitsmetall meistens ein oder mehrere Edelmetalle. In bestimmten Bereichen konnten die Edelmetalle teilweise oder vollständig durch andere Metalle, wie Aluminium und Silizium, ersetzt werden.

Gemäß US-Patent 4,039,721 werden Dickschicht-Leiterbahnen auf einem keramischen Substrat erhalten, indem einer Silberpulver-, Aluminiumpulver- und eine Borosilikat-Glasfritte enthaltende Paste auf das Substrat mittels Siebdruck aufgebracht und bei 800 °C - 1100°C eingebrannt wird. Der Partikeldurchmesser des Silberpulvers liegt unter 10 µm, jener des Aluminiumpulvers im Bereich von 6 - 20 µm.

Bei dem Anpastmedium handelt es sich um eine Lösung von Etyhlcellulose in Terpenalkohol-Isomeren. Nachteilig an dieser Paste ist, dass sie bei hohen Temperaturen eingebrannt werden muss und damit zur Herstellung von leitfähigen Beschichtungen auf Glas nicht in Frage kommt.

Die EP 1 087 646-A2 lehrt ein Verfahren zur Herstellung einer leitfähigen Beschichtung auf Glas, wobei die zu verwendende siebdruckfähige Aluminiumpaste 40 - 80 Gew.-% Aluminiumpulver mit einem d₅₀-Wert im Bereich von 1 bis 10 µm, 5 - 40 Gew.-% einer oder mehrerer Glasfritten mit einem Erweichungsbeginn im Bereich von 400°C - 700°C, 10 - 35 Gew.-% eines flüssigen oder thermoplastischen Mediums und fakultativ 0 - 40 Gew.-% Silberpulver enthält. Der spezifische Widerstand der leitfähigen Beschichtung nimmt mit zunehmendem Gehalt an Glasfritten in der Paste zu. Zwar lassen sich nach diesem Verfahren leitfähige Beschichtungen auf Glas mit einem spezifischen Widerstand im Bereich von etwa 25 - über 100 µΩ·cm erhalten, jedoch hängt der spezifische Widerstand in erheblichem Umfang von der gewählten Einbrenntemperatur ab. Sowohl eine Absenkung als auch Erhöhung der Brenntemperatur um mehr als 10°C gegenüber dem optimalen Brennbereich für ein betrachtetes System kann rasch zu einer Verdoppelung des spezifischen Widerstands führen. Die Steigerung des spezifischen Widerstands wird auf eine unvollständige Versinterung bzw. Oxidbildung zurückgeführt. Ein weiterer Nachteil dieser aluminiumhaltigen Leitfähigkeitspasten liegt darin, dass die damit erhaltenen leitfähigen Beschichtungen ganz spezielle Lötverfahren erforderlich machen, beispielsweise Ultraschalllöten unter Verwendung eines sehr speziellen Lötzinns.

Zu Herstellung von beheizbaren Heckscheiben werden derzeit im wesentlichen ausschließlich leitfähige Pasten auf der Basis von Silberpulvern verwendet. Die elektrischen Eigenschaften der Pasten sind auf die übliche Spannungen 12 V abgestimmt. Unter Verwendung handelsüblicher Silberpasten hergestellte Leiterbahnen auf Kfz-Glas haben einen spezifischen Widerstand im Bereich von 2,5 - 12 µΩ·cm.

Es bestehen Bestrebungen, die Spannung in Kraftfahrzeugen über 12 V zu erhöhen, beispielsweise auf einen Wert im Bereich von 24 V bis 42 V. Bei einer Erhöhung der Spannung um den Faktor 2 oder 3 ist bei gleicher Leistung einer beheizbaren Heckscheibe der elektrische Widerstand der Leiterbahn um den Faktor 4 bzw. 9 zu erhöhen. Die Zusammensetzung der Leitfähigkeitspaste muss dem gemäßgeändert werden, so dass die eingebrannten elektrisch leitfähigen Beschichtungen den geforderten spezifischen Widerstand aufweisen. Gleichzeitig sollen aber die Lötbarkeit, die chemische Beständigkeit, die Haftung der Beschichtung auf dem Substrat sowie die Verträglichkeit mit gegebenenfalls anwesenden keramischen Pigmenten den Eigenschaften der bisher üblichen Silberpasten möglichst nahe kommen. Ein weiteres Erfordernis von Leitfähigkeitspasten richtet sich auf eine möglichst hohe Stabilität des spezifischen Widerstands in Anhängigkeit von der Einbrenntemperatur. Beispielsweise soll der spezifische Widerstand einer Beschichtung auf Glas bei einer Temperatur im Bereich von etwa 650°C - 700°C, insbesondere 660°C - 680°C, um weniger 15 % und vorzugsweise weniger als 10 % variieren.

Zur Herstellung von Leiterbahnen mit einem spezifischen Widerstand im Bereich von etwa 25 - 60 µΩ·cm sind im Handel Siebdruckpasten (beispielsweise SP1216 und SP 1217 der Anmelderin) erhältlich, welche bei einer Temperatur im Bereich von 600°C - 680°C im Schnellbrandverfahren eingebrannt werden können. Diese Pasten enthalten Silber-Leitfähigkeitspartikel, eine niedrig schmelzende Glasfritte, Pigmente und ein Anpastmedium. Nachteilig an diesen Pasten ist, dass sie nur mit speziellen Verfahren (Ultraschall) nicht lötbar sind und zusätzlich eine geringe Stabilität gegenüber der Einbrenntemperatur aufweisen - wie die Vergleichsbeispiele in der vorliegenden Anmeldung zeigen, steigt der spezifische Widerstand um etwa 20 % an, wenn die Einbrenntemperatur von 670°C auf 660°C abgesenkt wird.

Aufgabe der vorliegenden Erfindung ist es demgemäß, eine Leitfähigkeitspaste zur Herstellung einer leitfähigen Beschichtung auf Glas, Keramik oder emailliertem Stahl aufzuzeigen, welche ein höhere Stabilität gegenüber der Einbrenntemperatur aufweist. Insbesondere sollte der spezifische Widerstand einer unter Verwendung einer solchen Paste erhaltenen elektrisch leitfähigen Beschichtung auf Glas, welche im Schnellbrand bei einer Temperatur im Bereich von 660°C bis 680°C eingebrannt wurde, um weniger als 10 %, vorzugsweise weniger als 5 % variieren. Gemäß einer weiteren Aufgabe sollten die unter Verwendung einer erfindungsgemäßen Leitfähigkeitspaste erzeugten elektrisch leitfähigen Beschichtungen unter üblichen Bedingungen gelötet werden können, also keine speziellen Lötverfahren, wie Ultraschallöten oder Löten unter Schutzgasatmosphäre erforderlich machen. Gemäß einer weiteren Aufgabe der Erfindung sollte es möglich sein, durch eine einfache Veränderung der Menge eines wesentlichen Bestandteils der Leitfähigkeitspaste den spezifischen Widerstand im wesentlichen gleichförmig also nicht sprunghaft zu verändern. Weitere Aufgaben ergeben sich aus der nachfolgenden Beschreibung der Erfindung in ihren unterschiedlichen Ausführungsformen.

Gefunden wurde eine Leitfähigkeitspaste zur Herstellung einer leitfähigen Beschichtung auf Glas, Keramik oder emailliertem Stahl, umfassend Leitfähigkeitspartikel aus Silber, mindestens ein Unedelmetall enthaltende Leitfähigkeitspartikel, eine oder mehrere Glasfritten und ein Anpastmedium,
das dadurch gekennzeichnet ist,
dass die Unedelmetall enthaltenden Leitfähigkeitspartikel im wesentlichen aus Eisen, Kobalt, Nickel, Kupfer, Zink oder einer mindestens eines dieser Elemente enthaltenden Legierung bestehen und zusätzlich mit Silber.beschichtet sein können, die Unedelmetall enthaltenden Leitfähigkeitspartikel eine mittlere Partikelgröße d₅₀ im Bereich von 0,1 bis 15 µm und eine spezifische Oberfläche im Bereich von 1 bis 5 m²/g aufweisen, bis zu 80 Gew.-% aller Leitfähigkeitspartikel Unedelmetall enthaltende Leitfähigkeitspartikel sind und die eine oder mehrere. Glasfritten einen Erweichungsbeginn (Erhitzungsmikroskop) im Bereich von 350°C bis 600°C und eine Halbkugeltemperatur im Bereich von 450°C - 700°C aufweisen.

Die weiteren Ansprüche richten sich auf bevorzugte Ausführungsformen der Leitfähigkeitspaste, auf deren Verwendung, ein Verfahren zur Herstellung der elektrisch leitfähigen Beschichtung unter Verwendung der Leitfähigkeitspaste sowie auf Artikel mit einer leitfähigen Beschichtung auf Glas, Keramik oder emailliertem Stahl, welche unter Verwendung einer erfindungsgemäßen Leitfähigkeitspaste erhältlich sind.

Es wurde gefunden, dass eine Leitfähigkeitspaste, welche neben Silber-Leitfähigkeitspartikeln spezielle Unedelmetall-Leitfähigkeitspartikel und zusätzlich einen niedrig schmelzenden Glasfluss aus einer oder mehreren Glasfritten enthält, nach Applikation auf einem Substrat und einem üblichen Brand, insbesondere einem Schnellbrand bei einer Temperatur im Bereich von 650°C bis etwa 700°C, zu einer elektrisch leitfähigen Beschichtung führt, welche einen spezifischen Widerstand aufweist, der größer ist als derjenige, welcher unter Verwendung einer Leitfähigkeitspaste mit ausschließlich Silber-Leitfähigkeitspartikeln erhältlich ist. Durch Steigerung des Anteils an Unedelmetall-Leitfähigkeitspartikeln, bezogen auch die gesamte Menge an Leitfähigkeitspartikeln, kann der spezifische Widerstand einer hieraus hergestellten elektrisch leitfähigen Beschichtung im wesentlichen gleichförmig gesteigert werden, so dass ohne Probleme Beschichtungen mit einem spezifischen Widerstand im Bereich von 10 - über 100 µΩ·cm erhältlich sind.

Eigenschaftssprünge wie sie aus Silber- und Aluminium enthaltenden Leitfähigkeitspasten bekannt waren, treten bei den erfindungsgemäßen Leitfähigkeitspasten nicht oder im wesentlich geringerem Umfang auf. Demgemäß zeichnen sich die erfindungsgemäßen Leitfähigkeitspasten auch durch eine hohe Stabilität gegenüber der Einbrenntemperatur auf. Für die Praxis bedeutet dies, dass bei einer Abweichung der Brenntemperatur von ± 10°C von einem angestrebten Wert, der spezifische Widerstand der jeweils erhaltenen Beschichtung um weniger als 10 %, insbesondere weniger als 7 % von dem Wert abweicht, welcher bei der angestrebten Brenntemperatur erhalten wird. Der optimale Temperaturbereich für den Brand richtet sich einerseits nach dem Erweichungsverhalten der in der Paste enthaltenen Glasfritten sowie nach der Sintertemperatur der Unedelmetall enthaltenden Leitfähigkeitspartikel. Der aufgezeigte Vorteil erfindungsgemäßer Leitfähigkeitspasten richtet sich demgemäß auf eine Brenntemperatur oberhalb der höchsten Halbkugeltemperatur der anwesenden Glasfritten und vorzugsweise oberhalb der Temperatur, bei welcher die Leitfähigkeitspartikel zumindest teilweise zusammensintern.

Ein wesentlicher Vorteil erfindungsgemäßer Leitfähigkeitspasten besteht darin, dass diese in einfacher Weise mit üblicher Mitteln und üblichen Lötzinnmaterialien für die in der Paste enthaltenen Metalle gelötet werden können. Aufwendige Einrichtungen für eine Ultraschalllötung oder eine Lötung unter Schutzgasatmosphäre sind demgemäß nicht notwendig.

Die erfindungsgemäßen Leitfähigkeitspasten enthalten als Leitfähigkeitsmaterialien sowohl Partikel aus Silber als auch Partikel, welche mindestens ein Unedelmetall enthalten. Bei den Unedelmetall enthaltenden Partikeln handelt es sich insbesondere um Partikel aus im wesentlichen Eisen, Kobalt, Nickel, Kupfer, Zink sowie Legierungen, welche mindestens eines dieser Metalle enthalten. Als weiterer Legierungsbestandteil können die Legierungen ein weiteres Element aus der genannten Reihe enthalten oder ein anderes Metall, wie Silizium, Vanadium, Chrom, Mangan, Silber und Zinn. Gemäß einer bevorzugten Ausführungsform enthält die Leitfähigkeitpaste als Unedelmetall enthaltende Partikel Nickel- oder Kupferpartikel. Bei Nickel oder Kupfer enthaltenden Pasten liegt der Unedelmetallgehalt vorzugsweise unter 50 Gew.-%, insbesondere im Bereich von 5 bis 40 Gew.-%, bezogen auf alle Leitfähigkeitspartikel. Gemäß einer bezüglich der Eigenschaftskombination besonders bevorzugten Form enthält die Paste als Leitfähigkeitspartikel im wesentlichen ausschließlich Silber- und Nickelpartikel.

Silber- und Bronzepartikel enthaltende Pasten zeigen trotz eines sehr hohen Bronzeanteils von z.B. um 70 Gew.-% einen überraschend niedrigen spezifischen Widerstand. Vorteilhaft ist hier die Einsparung an Silber.

Es ist auch möglich, dass die Unedelmetall enthaltenden Leitfähigkeitspartikel auch mit einer dünnen Silberumhüllung beschichtet sind. Derartige Beschichtungen lassen sich in an sich bekannter Weise durch Reduktion einer Silberverbindung aus wässriger Phase an der Unedelmetalloberfläche gewinnen. Mit Silber beschichtete Unedelmetall enthaltende Partikel eigenen sich insbesondere zur Verwendung in solchen Pasten, welche eine Beschichtung mit relativ niedrigem spezifischen Widerstand geben sollen.

Erfindungsgemäße Leitfähigkeitspasten enthalten Silberpartikel mit einem Kornspektrum und einer spezifischen Oberfläche, wie sie in vorbekannten Silber-Leitfähigkeitspasten Anwendung finden. Mikrokristalline Pulver mit im wesentlichen in kugeliger Form weisen dabei einen mittleren Teilchendurchmesser d₅₀ kleiner 6 µm und einer spezifischen Oberfläche von 1 bis 2 m²/g auf. Bei alternativ verwendbaren Silberpartikeln handelt es sich um ein Pulver aus blättchenförmigen Partikeln mit einem mittleren Durchmesser im Bereich von 7 bis 11 µm und eine spezifischen Oberfläche im Bereich von 1,5 m²/g. Einsetzbar sind auch Silberpartikel mit einem mittleren Teilchendurchmesser und einer spezifischen Oberfläche außerhalb der genannte Bereiche. Üblicherweise wird der mittlere Teilchendurchmesser d₅₀ im Bereich von 0,1 bis 15 µm und vorzugsweise 1 - 10 µm liegen.

Die Unedelmetall enthaltenden Leitfähigkeitspartikel weisen im allgemeinen eine mittlere Partikelgröße d₅₀ im Bereich von 0,1 bis 15 µm, insbesondere 0,2 bis 10 µm auf. Die spezifische Oberfläche der Unedelmetall enthaltenden Leitfähigkeitspartikel, gemessen nach BET(N₂-Absorption) oder aus Berechnungen aus dem Kornspektrum, liegt im Bereich von 1 bis 5m²/g.

Wie bereits ausgeführt, kann der spezifische Widerstand der elektrisch leitfähigen Beschichtung durch den Mengenanteil an Unedelmetall enthaltenden Leitfähigkeitspartikeln gesteuert werden, wobei der spezifische Widerstand mit zunehmender Menge an diesen Unedelmetall enthaltenden Partikeln zunimmt. Obgleich bereits eine geringe Menge an Unedelmetall enthaltenden Leitfähigkeitspartikeln wie 0,1 bis 1 Gew.-%, bezogen auf die Summe der Leitfähigkeitspartikel, bereits zu einer Steigerung des spezifischen Widerstands führt, enthalten erfindungsgemäß Leitfähigkeitspasten meist mehr als 1 Gew.-%, vorzugsweise 5 bis 40 Gew.-%, besonders bevorzugt 10 bis 35 Gew.-% Unedelmetall enthaltende Leitfähigkeitspartikel.

Durch die Verwendung einer oder mehrerer Glasfritten als Glasfluss in der erfindungsgemäßen Leitfähigkeitspaste, wird die hohe Stabilität der Paste gegenüber der Einbrenntemperatur erreicht. Gleichzeitig wurde es möglich, die Menge an Glasfluss auf einem niedrigen Niveau zu halten. Üblicherweise enthält die Paste 1 bis 12 Gew.-% an einer oder mehreren Glasfritten und vorzugsweise 2 bis 10 Gew.-%. Die Glasfritten werden in für Beschichtungszwecke, üblicher Körnung eingesetzt. Üblicherweise liegt der d₅₀-Wert im Bereich von 0,5 bis 10 µm, vorzugsweise im Bereich von 1 bis 5 µm. Zweckmäßigerweise ist der d₉₀-Wert kleiner 15 µm, insbesondere kleiner 10 µm und der d₁₀-Wert größer 02 µm, vorzugsweise größer 0,5 µm. Eine Glasfritte mit einem Kornspektrum im Bereich der zuvor genannten Werte ist für den Einsatz einer siebdruckfähigen Leitfähigkeitspaste bestens geeignet. Die erfindungsgemäß zu verwendenden Glasfritten weisen einen niedrigen Erweichungsbeginn, nämlich einen solchen im Bereich von 350°C bis 600°C, und eine niedrige Halbkugeltemperatur, nämlich eine solche im Bereich von 450°C - 700°C auf. Bei der Halbkugeltemperatur entspricht der Radius der Basisfläche der Höhe des zu einer Halbkugel geschmolzenen Presslings mit einem Durchmesser und einer Höhe von jeweils 3 mm. Sowohl der Erweichungsbeginn als auch die Halbkugeltemperatur werden zweckmäßigerweise im Erhitzungsmikroskop an genormten zylinderförmigen Presslingen des Glasfrittenpulvers ermittelt.

Einsetzbar sind sowohl Bleiborosilikatglasfritten als auch bleifreie Glasfritten. Unter den bleifreien Glasfritten sind zinkhaltige, bismuthaltige oder zink- und bismuthaltige Glasfritten gut geeignet. Bei einer weiteren Klasse von geeigneten Glasfritten handelt es sich um solche, auf der Basis von SiO₂, B₂O₃, TiO₂ und K₂O als wesentlichen Komponenten. Der Fachwelt sind derartige Glasfritten mit einem Erweichungsverhalten im geforderten Temperaturbereich wohl bekannt. Beispielhafte Frittezusammensetzungen mit deren obligatorischen Komponenten sind folgenden Dokumenten zu entnehmen:
EP 0 790 220 B (in Mol-%): SiO₂ 30-55, B₂O₃ 10-25, TiO₂ 15-30, K₂O 10-17;
EP 0 728 710 B (in Mol-%): SiO₂ 40-50, B₂O₃ 8-14, ZnO 13-19, TiO₂ 4-7, Na₂O 10-15, K₂O 0,1-2, F 1-5, Al₂O₃ 0,1-3;
EP 0 267 154 B (in Mol-%): SiO₂ 45-60, B₂O₃ 6-13, ZnO 8-25, Na₂O 5-14;
EP 0 558 942 (in Mol-%): Si0₂ 10-44, B₂O₃ 11-35, ZnO 31-50, Na₂O 11-25;
EP 0 854 120 A (in Gew.-%): SiO₂ 10-25, B₂O₃ 2-20, ZnO 3-15, Bi₂O₃ 20-55, Na₂O 1-10;
EP 0 803 480 A (in Gew.-%): SiO₂ 10-25, B₂O₃ 20-40, ZnO 10-50, Bi₂O₃ 0-15, Na₂O 7-10;
US 5,714,420 (in Gew.-%): SiO₂ 20-35, B₂O₃ 5-15, ZnO 5-45, Bi₂O₃ 10-50, Na₂O.

Zu Modifizierung der elektrisch leitfähigen Beschichtung hinsichtlich der elektrischen Eigenschaften, der Haftung der Beschichtung auf dem Substrat, der Kratzfestigkeit sowie der Farbe können der Leitfähigkeitspaste in begrenztem Umfang modifizierende Komponenten hinzugefügt werden. Bei diesen modifizierenden Komponenten handelt es sich beispielsweise um farbgebende Pigmente um Metallsulfide, wie Zinksulfid zwecks Reduzierung der Migration von Silberionen während des Brandes, um oxidbildende Vorstufen, wie Resinate, zwecks Modifizierung der elektrischen Eigenschaften und/oder der Haftung auf dem Substrat. Die modifizierenden Komponenten können in einer Menge bis zu etwa 15 Gew.-% in der Leitfähigkeitspaste enthalten sein. Selbstverständlich wird der spezifische Widerstand der eingebrannten leitfähigen Beschichtung mit zunehmender Menge an beispielsweise oxidischen Modifizierungskomponenten erhöht. Sofern ein spezifischer Widerstand um/unter 50 µΩ·cm betragen soll, wird der Gehalt an modifizierenden Komponenten im allgemeinen unter 10 Gew.-% und vorzugsweise unter 5 Gew.-%, bezogen auf die Paste, liegen.

Gemäß einer weiteren Ausführungsform kann es sich bei den modifizierenden Komponenten auch um pulverförmige Hilfsmittel handeln, welche bei gegebener Brenntemperatur zu einem höheren Grad der Sinterung der Silberpartikel sowie der Unedelmetall enthaltenden Leitfähigkeitspartikel führen. Beispiele für Sinterhilfsmittel sind Metalle, wie Zink, Magnesium, Bor und Silizium, insbesondere Zink und Magnesium, wobei Zink bereits unter den Unedelmetall enthaltenden Leitfähigkeitspartikeln genannt wurde. Eine weitere Klasse von Sinterhilfsmitteln sind Fluoride, wie Cryolith (AlF₃ · 3 NaF), NaF, MgF₂, sowie Kohlenstoff. Die Wirkung der Sinterhilfsmittel kann in der Schmelzpunktserniedrigung und/oder in ihrer reduzierenden Wirkung während des Brandes liegen.

Wesentlicher Bestanteil erfindungsgemäßer Leitfähigkeitspasten ist auch ein flüssiges oder thermoplastisches Medium, in welchem die Leitfähigkeitspartikel, die Glasfritten und gegebenenfalls anwesenden modifizierenden Komponenten gleichmäßig dispergiert sind. Bevorzugt werden flüssige organische Medien, welche ein oder mehrere polymere Bindemittel und/oder ein oder mehrere Lösungsmittel enthalten. Der Bindemittelgehalt im Medium wird so gewählt, dass nach dem Trocknen der mittels eines Beschichtungsverfahrens, beispielsweise eines Siebdruckverfahrens, erhaltene Film ausreichend grifffest ist. Besonders geeignet ist eine Bindemittelmenge im Bereich von 0,5 bis 10 Gew.-%, insbesondere 1 bis 5 Gew.-% bezogen auf die Leitfähigkeitspaste .

Die Bindemittelauswahl ist wenig kritisch, sofern sich die Bindemittel unter den Brennbedingungen zersetzen und/oder verbrennen und dabei vollständig verflüchtigen. Geeignet sind beispielsweise Celluloseether, Acryl- und Methacrylsäureester, Naturharze, Kolophoniumharze und modifizierte Alkydharze.

Bei den organischen Lösungsmitteln als Bestandteil des Mediums handelt es sich um solche, welche sich beim Brand blasenfrei verflüchtigen, das Bindemittel lösen können und die Einstellung einer geeigneten Verarbeitungsviskosität der Leitfähigkeitspaste ermöglichen. Beispiele sind Terpenalkohole und Terpenkohlenwasserstoffe; Glykole, Di- und Triglykole sowie Ether und Ester derselben; cyclische und verzweigte Kohlenwasserstoffe, wie Isoparaffine mit einem Siedepunkt im Bereich von 160 bis 250 °C; Alkohole, Ether und Ester mit einem Siedepunkt im Bereich von 70 bis 250 °C, insbesondere 100 bis 220 °C. Die Einsatzmenge Lösungsmittel richtet sich nach der gewünschten Viskosität. Die erfindungsgemäß zu verwendende Leitfähigkeitspaste lässt sich in für keramische Druckpasten üblicher Weise herstellen, nämlich durch intensives Mischen der Komponenten, beispielsweise in einem Dreiwalzenstuhl, Dispergator oder in einer Kugelmühle.

Gemäß einer bevorzugten Ausführungsform enthält die Leitfähigkeitspaste 40 bis 85 Gew.-% Leitfähigkeitspartikel, besonders bevorzugt sind Silber- und Nickelpartikel, 1 bis 12 Gew.-% Glasfritte(n), 10 bis 50 Gew.-% Medium, und 0 bis 15 Gew.-% Stoffe zur Modifizierung. Gemäß einer besonders bevorzugten Ausführungsform enthält die Paste 50 bis 80 Gew.-% Leitfähigkeitspartikel, 2 bis 10 Gew.-% Glasfritte(n), 15 bis 48 Gew.-% Medium und 0 bis 15 Gew.-% Stoffe zur Modifizierung.

Gemäß einer besonders bevorzugten Ausführungsform handelt es sich bei den zu verwendenden Glasfritten um solche, welche schnellbrandfähig sind, also innerhalb von etwa 1 bis 10 Minuten, vorzugsweise aber 2 bis 5 Minuten bei einer Temperatur im Bereich von 660°C bis 680°C auf Glas eingebrannt werden können. Die erfindungsgemäßen Leitfähigkeitspasten lassen sich zur Herstellung leitfähiger Beschichtungen auf brandfähigen Substraten, insbesondere also Glas, Keramik und emailliertem Stahl verwenden. Die Herstellung einer derartigen Beschichtung umfasst das Aufbringen einer Schicht einer Leitfähigkeitspaste auf das Substrat und einen Brand des beschichteten Substrats bei einer Temperatur im Bereich von 450°C bis 700°C.

Der Auftrag der erfindungsgemäßen Leitfähigkeitspaste erfolgt mittels üblicher Verfahren, wie sie aus der Herstellung von Dekoren auf Glas oder Keramik bekannt sind. Es handelt sich um übliche direkte und indirekte Druckverfahren, insbesondere Siebdruckverfahren. Auch ein Auftrag durch Spritzen, Tauchen oder mittels anderer Dekorauftragstechniken ist möglich.

Bei den zu beschichtenden Substraten handelt es sich um solche aus Glas, Keramik oder emailliertem Stahl, insbesondere Glasscheiben, wie Glasscheiben für Kraftfahrzeuge.

Der Brand des beschichteten Substrats erfolgt bei einer auf das Substrat, das Erweichungsverhalten der anwesenden Glasfritte(n) sowie das Sinterverhalten der Leitfähigkeitsmetalle abgestimmten Temperatur. Im Hinblick auf den üblicherweise niedrigen Erweichungspunkt der in einer erfindungsgemäßen Leitfähigkeitspaste enthaltenen Glasfritte erfolgt der Brand bei einer Temperatur im Bereich von etwa 550°C bis 750°C, vorzugsweise 590°C bis 700°C und besonders bevorzugt 650°C bis 690°C. Auf Glasscheiben für Kraftfahrzeuge wird die Leitfähigkeitspaste zweckmäßigerweise unter solchen Bedingungen eingebrannt, wie sie unter Verwendung bisheriger Leitfähigkeitspasten und/oder anderer Dekorpräparate üblich sind. Meistens handelt es sich hierbei um einen sogenannten Schock- oder Schnellbrand, wobei bei einer Temperatur im Bereich von etwa 640°C bis 700°C, vorzugsweise 650°C bis 700°C und besonders bevorzugt 660°C bis 680°C innerhalb von 1 Minute bis 10 Minuten, vorzugsweise 2 Minuten bis 5 Minuten eingebrannt wird.

Gegenstand der Erfindung sind auch Artikel mit einer leitfähigen Beschichtung auf Glas, Keramik oder emailliertem Stahl, wobei die Beschichtung unter Verwendung einer erfindungsgemäßen Leitfähigkeitspaste erhältlich ist.

Die Vorteile der erfindungsgemäßen Leitfähigkeitspasten wurden bereits zuvor dargelegt. Entsprechende Vorteile weisen auch die erfindungsgemäß erhältlichen Artikel mit einer elektrischen leitfähigen Beschichtung, welche unter Verwendung einer erfindungsgemäßen Leitfähigkeitspaste erhalten wurde, auf.

Die Erfindung wird anhand der nachfolgenden Beispiele und Vergleichsbeispiele weiter erläutert.

### Beispiele

Zur Herstellung der erfindungsgemäßen Leitfähigkeitspasten wurden folgende Komponenten eingesetzt:
◆ Ag-Pulver Typ "3X": mikrokristalliner Typ: d₅₀ kleiner 6 µm, spezifische Oberfläche 1,1 - 1,8 m²/g (Herstellerangaben)
◆ Ag-Flakes Typ "D12": blättchenförmig Typ, D₅₀ 7 - 11 µm, spezifische Oberfläche 1,0 - 1,5 m²/g (Herstellerangaben)
◆ Ni-Pulver: d₅₀ 5 - 6 µm, spezifische Oberfläche 3,9 m²/g
◆ Cu-Pulver: d₅₀ 5 - 6 µm, spezifische Oberfläche 2 - 3 m²/g
◆ Bronze-Pulver; d₅₀ 5 - 6 µm, spezifische Oberfläche 1,5 - 2,5 m²/g
◆ Glasfluss "GF1": Es handelt sich um eine zinkoxidhaltige Glasfritte mit den Hauptkomponenten (Gew.-%): ZnO (37), B₂O₃ (22), SiO₂ (11), Na₂O (11), Al₂O₃ (5); Erweichungsbeginn 530°C, Halbkugeltemperatur 630°C, D₅₀ 2 - 3 µm.
◆ Glasfluss "GF2": Es handelt sich um eine Zinkoxid und Bismutoxid enthaltende Glasfritte mit den Hauptkomponenten (Gew.-%) Bi₂O₃ (42), ZnO (15), B₂O₃ (11), SiO (21), Na₂O (5), Ti0₂ (1,5), ZrO₂ (1,5); Erweichungsbeginn 550°C, Halbkugeltemperatur 680°C; d₅₀ 2 - 3 µm.
◆ Medium: Hydroxypropylcellulose (5 Gew.-%) in Diethylglykol-n-butylether.
◆ SP1216: Die Silberpaste des VB1 enthält 45 Gew.-% Ag, ca. 5 Gew.-% Glasfritte, etwa 16 Gew.-% Pigmente und 34 Gew.-% Medium.

Tabelle 1 zeigt Pastenzusammensetzungen und den speziellen Widerstand nach Applikation mittels Siebdruck und Brand bei 670°C im Durchlaufofen, 4 Minuten.

**Tabelle 1**

| Nr. | Ag-Typ | | Nickel Gew.-% | Glasfritte | | Medium Gew.-% | Spez. Widerstand µΩ·cm |
|---|---|---|---|---|---|---|---|
| | Kristallin | Blättchenförmig | | GF1 | GF2 | | |
| | Gew.-% | | | Gew.-% | | | |
| 1 | 34,5 | - | 34,5 | 6 | - | 25 | 550 |
| 2 | 46,3 | - | 22,7 | 6 | - | 25 | 70 |
| 3 | 51,7 | - | 17,3 | 6 | - | 25 | 40 |
| 4 | 55,4 | - | 13,6 | 6 | - | 25 | 29 |
| 5 | 51,7 | - | 17,3 | 2 | 4 | 25 | 40 |
| 6 | 25,8 | 25,8 | 17,3 | 2 | 4 | 25 | 39 |

Tabelle 2 zeigt die Stabilität der Pasten Nr. 5 und 6 im Vergleich zu einer handelsüblichen Silberpaste (SP1216) (=VB1). Gebrannt wurde bei 660°C, 670°C und 680°C im Durchlaufofen, jeweils 4 Minuten. Während der spezifische Widerstand der erfindungsgemäßen Pasten nur wenig von der Brenntemperatur abhängt, resultiert bei der Paste des VB1 eine große Temperaturabhängigkeit.

**Tabelle 2**

| Nr. | Brenntemperatur (°C) | Spez. Widerstand µΩ · cm |
|---|---|---|
| VB 1 | 660 | 31 |
| | 670 | 25,8 |
| | 680 | 24,7 |
| 5 | 660 | 37,8 |
| | 670 | 40,1 |
| | 680 | 38,2 |
| 6 | 660 | 39,7 |
| | 670 | 38,5 |
| | 680 | 38,3 |

Die erfindungsgemäßen Pasten zeigen eine gute Lötbarkeit mit bekannten Verfahren, wie sie in der Autoglasindustrie allgemein Anwendung finden; Paste Nr. 6 zeigt die beste Lötbarkeit.

Tabelle 3 zeigt die Zusammensetzung und den spezifischen Widerstand von Kupferpulver bzw. Bronzepulver enthaltenden-Pasten. Die Pasten enthielten jeweils 6 Gew.-% der Glasfritte GF1 und 25 Gew.-% des Mediums. Gebrannt wurde bei 670°C in 4 Minuten im Durchlaufofen.

**Tabelle 3**

| Nr. | Ag-Typ kristallin (Gew.-%) | Unedelmetall | | Spez. Widerstand |
|---|---|---|---|---|
| | | Cu | Bronze | |
| | | (Gew.-%) | | (µΩ·cm) |
| 7 | 34,5 | 34,5 | | 76,2 |
| 8 | 42,8 | 26,2 | | 30,9 |
| 9 | 46,3 | 22,7 | | 22,4 |
| 10 | 20,1 | | 48,9 | 34,6 |
| 11 | 34,5 | | 34,5 | 10,6 |
| 12 | 46,3 | | 22,7 | 5,8 |

## Patentansprüche

1. Leitfähigkeitspaste zur Herstellung einer leitfähiger Beschichtung auf Glas, Keramik oder emailliertem Stahl, umfassend Leitfähigkeitspartikel aus Silber, mindestens ein Unedelmetall enthaltende Leitfähigkeitspartikel, eine oder mehrere Glasfritten und ein Anpastmedium,
**dadurch gekennzeichnet,**
**dass** die Unedelmetall enthaltenden Leitfähigkeitspartikel im wesentlichen aus Eisen, Kobalt, Nickel, Kupfer, Zink oder einer mindestens eines dieser Elemente enthaltenden Legierung bestehen und zusätzlich mit Silber beschichtet sein können, die Unedelmetall enthaltenden Leitfähigkeitspartikel eine mittlere Partikelgröße d₅₀ im Bereich von 0,1 bis 15 µm und eine spezifische Oberfläche im Bereich von 1 bis 5 m²/g aufweisen, bis zu 80 Gew.-% aller Leitfähigkeitspartikel Unedelmetall enthaltende Leitfähigkeitspartikel sind und die eine oder mehrere Glasfritten einen Erweichungsbeginn (Erhitzungsmikroskop) im Bereich von 350°C bis 600°C und eine Halbkugeltemperatur im Bereich von 450°C - 700°C aufweisen.

2. Leitfähigkeitspaste nach Anspruch 1,
**dadurch gekennzeichnet,**
**dass** sie als Unedelmetall enthaltende Leitfähigkeitspartikel Nickel- oder Kupferpartikel in einer Menge bis zu 50 Gew.-%, insbesondere 10 bis 40 Gew.-% bezogen auf die Summe an Leitfähigkeitspartikel enthält.

3. Leitfähigkeitspaste nach Anspruch 1 oder 3,
**dadurch gekennzeichnet,**
**dass** sie mehr als 5 Gew.-%, insbesondere 10 bis 35 Gew.-% Unedelmetall enthaltende Leitfähigkeitspartikel, bezogen auf die Summe aller Leitfähigkeitspartikel, enthält.

4. Leitfähigkeitspaste nach einem der Ansprüche 1 bis 3,
**dadurch gekennzeichnet,**
**dass** sie in Gew.-% enthält:
| | |
|---|---|
| Leitfähigkeitspartikel | : 40 - 85 |
| Glasfritte(n) | : 1 - 12 |
| Medium | : 10 - 50 |
| Stoffe zu Modifizierung | : 0 - 15 |

5. Leitfähigkeitspaste nach Anspruch 4,
**dadurch gekennzeichnet,**
**dass** sie in Gew.-% enthält:
| | |
|---|---|
| Leitfähigkeitspartikel | : 50 - 80 |
| Glasfritte(n) | : 2 - 10 |
| Medium | : 15 - 48 |
| Stoffe zur Modifizierung | : 0 - 15 |

6. Leitfähigkeitspaste nach einem der Ansprüche 1 bis 5,
**dadurch gekennzeichnet,**
**dass** die Glasfritte(n) bleifrei ist (sind) und ausgewählt ist (sind) aus der Reihe der zink- und/oder bismuthaltigen Borosilikatgläser oder Gläser auf der Basis der Hauptkomponenten SiO₂, B₂O₃, TiO₂ und K₂O.

7. Leitfähigkeitspaste nach einem der Ansprüche 1 bis 6,
**dadurch gekennzeichnet, dass** die Glasfritte(n) schnellbrandfähig sind (2 - 5 min bei 660°C bis 680°C auf Glas).

8. Leitfähigkeitspaste nach einem der Ansprüche 1 bis 7,
**dadurch gekennzeichnet,**
**dass** das Anpastmedium ein organisches Bindemittel, insbesondere ein Cellulosederivat, und ein oder mehrere Lösungsmittel, insbesondere Glycoletherverbindungen und Terpenalkohole, enthält oder im wesentlichen auf einem thermoplastischen Polymer basiert.

9. Leitfähigkeitspaste nach einem der Ansprüche 1 bis 8,
**dadurch gekennzeichnet,**
**dass** die Paste siebdruckfähig ist.

10. Verwendung der Leitfähigkeitspaste gemäß einem der Ansprüche 1 bis 9 zur Herstellung einer leitfähigen Beschichtung auf einem brandfähigen Substrat, insbesondere Glas, Keramik und emailliertem Stahl.

11. Verfahren zu Herstellung einer leitfähigen Beschichtung auf einem brandfähigen Substrat, insbesondere Glas, Keramik und emailliertem Stahl, umfassend Aufbringen einer Schicht aus einer Leitfähigkeitspaste auf das Substrat und Brennen des beschichteten Substrats bei einer Temperatur im Bereich von 450 - 700°C,
**dadurch gekennzeichnet,**
**dass** man eine Leitfähigkeitspaste gemäß einem der Ansprüche 1 bis 9 verwendet.

12. Artikel mit einer leitfähigen Beschichtung auf Glas, Keramik oder emailliertem Stahl,
**dadurch gekennzeichnet, dass** die Beschichtung unter Verwendung einer Leitfähigkeitspaste gemäß einem der Ansprüche 1 bis 9 erhältlich ist.

## Claims

1. Conductive paste for producing a conductive coating on glass, ceramics or enamelled steel, comprising conductive particles of silver, conductive particles containing at least one base metal, one or more glass frits and a paste-forming medium,
**characterised in that**
the base-metal-containing conductive particles consist substantially of iron, cobalt, nickel, copper, zinc or an alloy containing at least one of those elements and can additionally be coated with silver, the base-metal-containing conductive particles have a mean particle size d₅₀ in the range from 0.1 to 15 µm and a specific surface area in the range from 1 to 5 m²/g, up to 80 wt.% of all the conductive particles are base-metal-containing conductive particles, and the one or more glass frits have a softening point (heating microscope) in the range from 350°C to 600°C and a hemisphere temperature in the range from 450°C to 700°C.

2. Conductive paste according to claim 1,
**characterised in that**
it contains as the base-metal-containing conductive particles nickel or copper particles in an amount of up to 50 wt.%, in particular from 10 to 40 wt.%, based on the sum of the conductive particles.

3. Conductive paste according to claim 1 or 2 ,
**characterised in that**
it contains more than 5 wt.%, in particular from 10 to 35 wt.%, base-metal-containing conductive particles, based on the sum of all conductive particles.

4. Conductive paste according to any one of claims 1 to 3,
**characterised in that**
it contains, in wt.%:
| | |
|---|---|
| conductive particles | : from 40 to 85 |
| glass frit(s) | : from 1 to 12 |
| medium | : from 10 to 50 |
| substances for modification | : from 0 to 15. |

5. Conductive paste according to claim 4,
**characterised in that**
it contains, in wt.%:
| | |
|---|---|
| conductive particles | : from 50 to 80 |
| glass frit(s) | : from 2 to 10 |
| medium | : from 15 to 48 |
| substances for modification | : from 0 to 15. |

6. Conductive paste according to any one of claims 1 to 5,
**characterised in that**
the glass frit(s) is (are) lead-free and is (are) selected from the group of the zinc- and/or bismuth-containing borosilicate glasses or glasses based on the main components SiO₂, B₂O₃, TiO₂ and K₂O.

7. Conductive paste according to any one of claims 1 to 6,
**characterised in that**
the glass frit(s) can be fired rapidly (from 2 to 5 minutes at from 660°C to 680°C on glass).

8. Conductive paste according to any one of claims 1 to 7,
**characterised in that**
the paste-forming medium contains an organic binder, in particular a cellulose derivative, and one or more solvents, in particular glycol ether compounds and terpene alcohols, or is based substantially on a thermoplastic polymer.

9. Conductive paste according to any one of claims 1 to 8,
**characterised in that**
the paste can be screen printed.

10. Use of the conductive paste according to any one of claims 1 to 9 in the production of a conductive coating on a firable substrate, in particular glass, ceramics and enamelled steel.

11. Method of producing a conductive coating on a firable substrate, in particular glass, ceramics and enamelled steel, which comprises applying a layer of a conductive paste to the substrate and firing the coated substrate at a temperature in the range of from 450 to 700°C,
**characterised in that**
a conductive paste according to any one of claims 1 to 9 is used.

12. Article having a conductive coating on glass, ceramics or enamelled steel,
**characterised in that** the coating is obtainable using a conductive paste according to any one of claims 1 to 9.

## Revendications

1. - Pâte de conductivité pour la fabrication d'un revêtement conducteur sur du verre, de la céramique ou de l'acier émaillé, comprenant des particules de conductivité constituées d'argent, des particules de conductivité contenant au moins un métal non noble, une ou plusieurs frittes de verre et une substance de formation de pâte,
**caractérisée par le fait que**
les particules de conductivité contenant du métal non noble se composent essentiellement de fer, de cobalt, de nickel, de cuivre, de zinc ou d'un alliage contenant au moins l'un de ces éléments et peuvent être revêtues additionnellement par de l'argent, les particules de conductivité contenant du métal non noble présentent une grosseur moyenne de particule d₅₀ se situant dans la plage de 0,1 à 15 µm et une surface spécifique se situant dans la plage de 1 à 5 m²/g, une quantité allant jusqu'à 80% en poids de toutes les particules de conductivité est constituée par des particules de conductivité contenant du métal non noble et la ou les différentes frittes de verre présentent un début de ramollissement (microscope chauffant) se situant dans la plage de 350°C à 600°C et une température de demi-sphère se situant dans la plage de 450°C-700°C.

2. - Pâte de conductivité selon la revendication 1,
**caractérisée par le fait**
**qu'**elle contient, en tant que particules de conductivité contenant du métal non noble, des particules de nickel ou de cuivre dans une quantité allant jusqu'à 50% en poids, en particulier de 10 à 40% en poids par rapport à la somme des particules de conductivité.

3. - Pâte de conductivité selon l'une des revendications 1 ou 2 ,
**caractérisée par le fait**
**qu'**elle contient plus de 5% en poids, en particulier 10 à 35% en poids, de particules de conductivité contenant du métal non noble, par rapport à la somme de toutes les particules de conductivité.

4. - Pâte de conductivité selon l'une des revendications 1 à 3,
**caractérisée par le fait**
**qu'**elle contient en % poids:
| | |
|---|---|
| Particules de conductivité | : 40 - 85 |
| Fritte(s) de verre | : 1- 12 |
| Substance de formation de pâte | : 10 - 50 |
| Substances de modification | : 0 - 15 |

5. - Pâte de conductivité selon la revendication 4,
**caractérisée par le fait**
**qu'**elle contient en % en poids :
| | |
|---|---|
| Particules de conductivité | : 50 - 80 |
| Fritte(s) de verre | : 2 - 10 |
| Substance de formation de pâte | : 15 - 48 |
| Substances de modification | : 0 - 15 |

6. - Pâte de conductivité selon l'une des revendications 1 à 5,
**caractérisée par le fait**
**que** la (ou les) frittes de verre est (ou sont) exempte(s) de plomb et est (ou sont) choisie(s) dans la série des verres de borosilicate à teneur en zinc et/ou en bismuth ou des verres à base de composants principaux SiO₂, B₂O₃, TiO₂ et K₂O.

7. - Pâte de conductivité selon l'une des revendications 1 à 6,
**caractérisée par le fait**
**que** la ou les frittes de verre sont aptes à la cuisson rapide (2- 5 minutes à 660°C à 680°C sur le verre).

8. - Pâte de conductivité selon l'une des revendications 1 à 7,
**caractérisée par le fait**
**que** la substance de formation de pâte contient un liant organique, en particulier un dérivé de cellulose, et un ou plusieurs solvants, en particulier des composés d'éthers de glycols et des alcools terpéniques, ou est basé essentiellement sur un polymère thermoplastique.

9. - Pâte de conductivité selon l'une des revendications 1 à 8,
**caractérisée par le fait**
**que** la pâte est sérigraphiable.

10. - Utilisation de la pâte de conductivité telle que définie à l'une des revendications 1 à 9, pour la fabrication d'un revêtement conducteur sur un substrat apte à la cuisson comprenant le verre, la céramique et l'acier émaillé.

11. - Procédé de fabrication d'un revêtement conducteur sur un substrat apte à la cuisson, en particulier le verre, la céramique et l'acier émaillé, comprenant l'application d'une couche d'une pâte de conductivité sur le substrat et la cuisson du substrat revêtu à une température se situant dans la plage de 450 - 700°C,
**caractérisé par le fait**
**que** l'on utilise une pâte de conductivité telle que définie à l'une des revendications 1 à 9.

12. - Article présentant un revêtement conducteur sur du verre, de la céramique ou de l'acier émaillé,
**caractérisé par le fait que** le revêtement est apte à être obtenu avec utilisation d'une pâte de conductivité telle que définie à l'une des revendications 1 à 9.
